# EUROPEAN PATENT APPLICATION

(11) **EP 1 398 837 A1**
(43) Date of publication of application: **17.03.2004**
(21) Application number: 02447171.6
(22) Date of filing: 09.09.2002
(51) Int. Cl.: H01L 31/028, H01L 31/072, H01L 31/075

(54) **Photovoltaic device**

(71) Applicant: INTERUNIVERSITAIR MICROELEKTRONICA CENTRUM ( IMEC), 3001 Leuven (BE)
(72) Inventor: Bilyalov, Renat, 3390 Tielt-Winge (BE); Ulyashin, Alexander, 58085 Hagen (DE); Poortmans, Jef, 3010 Kessel-Lo (BE); Fahrner, Wolfgang, 58097 Hagen (DE)
(74) Representative: Van Malderen, Joelle

(57) **Abstract**

The present invention is related to a photovoltaic device, comprising a first layer of a first semiconductor material of a first conductivity type, a second layer of a second semiconductor material of the opposite conductivity type of the first layer, and a third layer of a third semiconductor material located between the first layer and the second layer which is porous. The present invention also provides a method for producing the photovoltaic device.

## Description

### Field of the invention

The present invention is related to the field of photovoltaic devices.

### State of the art

Within photovoltaic research, one tends to develop cost-effective solar cells, which provide a high efficiency. The costs for producing for instance silicon material based solar cells can be divided into 3 parts; the material costs, which make up the biggest part and are strongly dependent on the quality of the used silicon, which is a function of its grain size, the solar cell process cost and the module process cost.

A certain type of cells, so-called HIT cell (Hetero junction with Intrinsic Thin-layer) are state of the art and were developed to improve the junction properties of the classical hetero junction cell.

US patent US5,213,628 describes a photovoltaic device including a substantially intrinsic substantially amorphous semiconductor layer formed on a mono crystalline or poly crystalline semiconductor layer of one conductivity type, on which a substantially amorphous semiconductor layer, being of the opposite conductivity type, is formed.

US patent US5,066,340 describes a photovoltaic device including a crystalline silicon semiconductor layer of a first conductivity type material, an amorphous silicon semiconductor layer of the opposite conductivity type and a substantially intrinsic micro crystalline silicon semiconductor layer between these 2 layers.

### Aims of the invention

The present invention aims to describe a novel solar cell, which combines a high efficiency and a low price. The invention contributes to the continuous efforts performed by industry to improve the quality of solar cells and reduce their production costs.

### Summary of the invention

In a first aspect of the invention, a photovoltaic device is disclosed, the device comprising a first layer based on a first semiconductor material of a first conductivity type, a second layer based on a second semiconductor material of the opposite conductivity type of the first layer, and a third layer of porous semiconductor material, based on a third semiconductor material, located between the first layer and the second layer. These three layers are preferably physically attached to each other.

The first, second and third semiconductor materials can be based on the same chemical composition or can be based on a different composition. Preferably the second and third semiconductor materials are based on the same chemical composition. Most preferably the second and third semiconductor material are based on silicon.

In a first embodiment of the first aspect of the present invention, the third semiconductor material is based on substantially non-doped semiconductor material.

In a further embodiment of the first aspect and possibly combined with the first embodiment of the first aspect of the present invention, the third semiconductor material is based on crystalline semiconductor material, preferably mono crystalline or multi crystalline.

According to a further embodiment of the first aspect of the present invention and possibly combined with any of the previously mentioned embodiments, the first semiconductor material is based on substantially amorphous semiconductor material, substantially nano crystalline semiconductor material or substantially microcrystalline semiconductor material.

According to a further embodiment of the first aspect of the present invention and possibly combined with any of the previously mentioned embodiments, the second semiconductor material is based on crystalline semiconductor material, with specific embodiments of having the second semiconductor material based on mono crystalline or multi crystalline semiconductor material.

According to a further embodiment of the first aspect of the present invention and possibly combined with any of the previously mentioned embodiments, the first layer has a thickness between 3nm and 100nm.

According to a further embodiment of the first aspect of the present invention and possibly combined with any of the previously mentioned embodiments, the third layer has a thickness between 1nm and 50nm.

A first method is disclosed for producing a photovoltaic device comprising the steps of providing the second layer, depositing the third layer on the second layer and depositing the first layer on the third layer, whereby the layers are as described before.

In a second aspect of the present invention, a photovoltaic device is disclosed, whereby the second layer of is further attached to a fourth layer which is porous and based on substantially non-doped crystalline semiconductor material, which is on its turn attached to an fifth layer based on amorphous, nano crystalline or microcrystalline silicon semiconductor material and of the same conductivity type as the second layer.

A second method is disclosed which is based on the first method, further comprising the steps of depositing the fourth layer on the second layer and depositing the fifth layer on the fourth layer.

### SHORT DESCRIPTION OF FIGURES

Fig. 1 shows a schematic representation of an aspect of the invention.

Fig. 2 shows a schematic representation of another aspect of the invention.

Fig. 3 shows the relation between the short circuit current [*mA*/*cm*^{*2*}] and the thickness of porous layer is depicted.

Fig. 4 illustrates the relation between open circuit voltage [mV] versus thickness of porous layer.

Fig. 5 shows the relation between efficiency [%] and thickness of porous layer is represented.

Fig. 6 shows the fill factor [%] values for different values of porous layer thickness.

### Detailed description of the invention

The following description and examples illustrate preferred embodiments of the present invention in detail. Those of skill in the art will recognize that there are numerous variations and modifications of this invention that are encompassed by its scope. Accordingly, the description of preferred embodiments should not be deemed to limit the scope of the present invention.

For the purpose of this invention, the naming of crystals is based on their grain sizes, and is represented in Tab. 1. The term "crystalline silicon" refers to silicon of all crystal types except amorphous silicon.

**Tab. 1 :**

| naming of crystals based on their grain sizes | |
|---|---|
| Grain size of silicon crystal | Name |
| Substantially Atomic size | Amorphous |
| <10 nm | Nano crystalline |
| <1 µm | Micro crystalline |
| <100 µm | Poly crystalline |
| <1 mm | Multi crystalline |
| Infinite | Mono crystalline |

For the purpose of this invention, semiconductor material can be, but is not limited to, Si: Silicon, Ge: Germanium, GaP: Gallium Phosphide, GaAs: Gallium Arsenide, InAs: Indium Arsenide, C: Diamond, GaSb: Gallium Antimonide, InSb: Indium Antimonide, InP: Indium Phosphide, GaAS₁₋ₓSbₓ: Gallium Arsenide Antimonide, AlₓGa₁₋ₓAs: Aluminium Gallium Arsenide, GaₓIn₁₋ₓP: Gallium Indium Phosphide, GaₓIn₁₋ₓAs: Gallium Indium Arsenide, GaₓIn₁₋ₓSb: Gallium Indium Antimonide, InAs₁₋ₓSbₓ: Indium Arsenide Antimonide, GaₓIn₁₋ₓAS_{y}P_{1-y}: Gallium Indium Arsenide Phosphide, GaₓIn₁₋ₓAs_{y}Sb_{1-y}: Gallium Indium Arsenide Antimonide, GaN: Gallium Nitride, AlN: Aluminium Nitride, InN: Indium Nitride, whereby x and y are natural numbers. Preferably semiconductor material refers to Si, Ge, GaAs. Most preferably it is Silicon.

For the purpose of this invention the wording '...semiconductor material ... based on...' is used to indicate the possibilities of: (a) having impurities (called dopants in the art) typically introduced in the semiconductor material during doping procedures. (b) having impurities in the semiconductor material that do not bring significant changes in the conductivity properties of the semiconductor material.

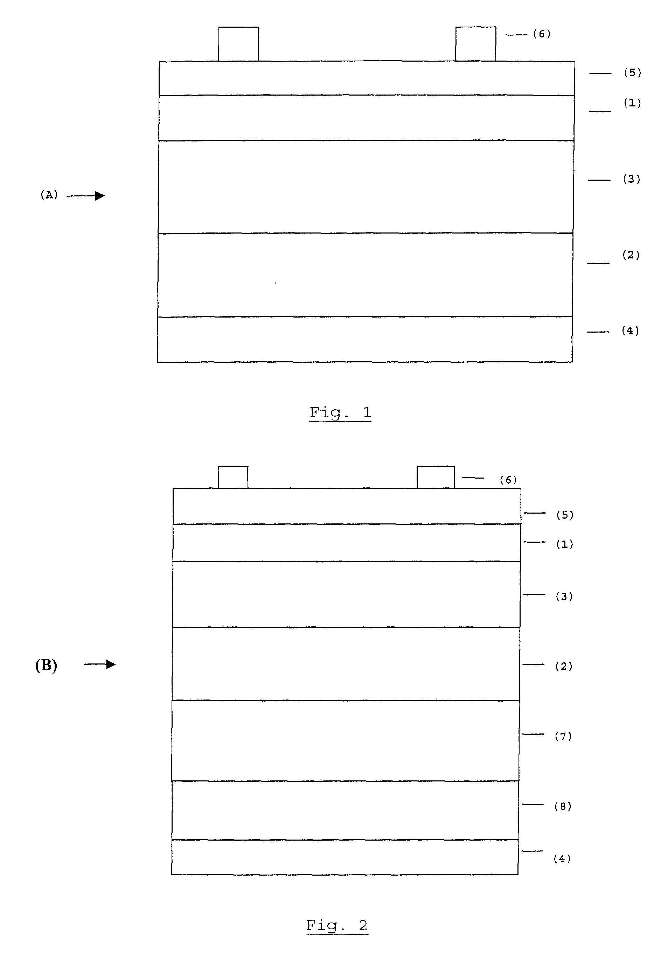

In a first aspect of the invention, a photovoltaic device is disclosed (Fig. 1A), comprising a first layer of a first semiconductor material of a first conductivity type (1), a second layer of a second semiconductor material of the opposite conductivity type (2) of the first layer, and a third layer made of porous semiconductor material (3) of a third semiconductor material, located between the first layer and the second layer. These three layers are preferably physically attached to each other. The first, second and third semiconductor materials can be based on the same chemical composition or can be based on a different composition. Preferably the second and third semiconductor materials are based on the same chemical composition. Most preferably the second and third semiconductor material are based on silicon.

In a typical production process the porous third layer can be created by elaboration of the second layer. The second layer can be, but is not limited to, a wafer or processed wafer. The first layer (called emitter layer in the art) can typically be covered with a conductive electrode layer (5), which can be substantially transparent and can be used for the transport of photon-generated electrons towards the front contacts (6). The conductive electrode layer can be made of for instance Indium Tin Oxide (ITO), SnO₂ or ZnO. On the backside of the second layer (called bulk layer in the art) a back electrode is provided (4), which can be substantially consisting of a metal as for instance, but not limited to, Aluminum, Silver, Nickel. The backside of the bulk layer is defined as the one of the substantially 2 surfaces of the bulk layer, which is the most distant from the third layer.

Porous semiconductor material is state-of-the-art. It is a medium substantially consisting of semiconductor material and voids, where the percentage of the total volume occupied by voids can be typically between 10% and 85%. The terms n-type conductivity and p-type conductivity are known to a person ordinary skilled in the art.

In a further embodiment of the first aspect of the present invention the third layer can be made of porous substantially non-doped semiconductor material. Non-doped semiconductor material is semiconductor material, which has not explicitly been doped or has no characteristics similar to such material and is also referred to in the art as 'intrinsic semiconductor material'.

In another embodiment of the first aspect of the present invention the third layer is made of porous substantially non-doped semiconductor material, which is based on crystalline semiconductor material. In another embodiment of the first aspect of the present invention the third layer is made of porous substantially non-doped silicon semiconductor material, based on crystalline semiconductor material, with specific embodiments of having the third layer made from mono crystalline silicon semiconductor material or multi crystalline silicon semiconductor material.

According to a further embodiment of the first aspect of the present invention and possibly combined with any of the previously mentioned embodiments, the first layer is based on substantially amorphous semiconductor material, substantially nano crystalline semiconductor material or substantially microcrystalline semiconductor material.

According to a further embodiment of the first aspect of the present invention and possibly combined with any of the previously mentioned embodiments, the second layer is based on crystalline semiconductor material, with specific embodiments of having the second layer based on mono crystalline or multi crystalline silicon semiconductor material.

In a further embodiment of the first aspect of the present invention; the second layer consists substantially of multi crystalline silicon semiconductor material of p-type conductivity, the first layer is made of amorphous silicon semiconductor material of n-type conductivity, and the third layer is made of porous non-doped silicon semiconductor material based on multi crystalline semiconductor material between the first layer and the second layer.

The thickness of the first layer is preferably within the range of [3nm, 100nm]. The thickness of the third layer is preferably within the range of [1nm, 50nm]. The second layer has a typical appropriate bulk layer thickness.

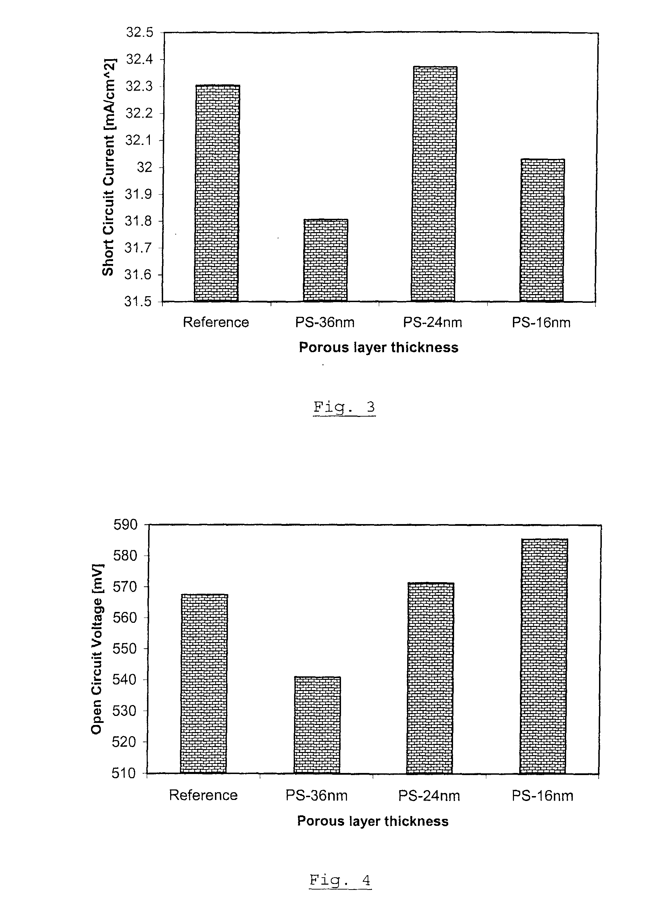

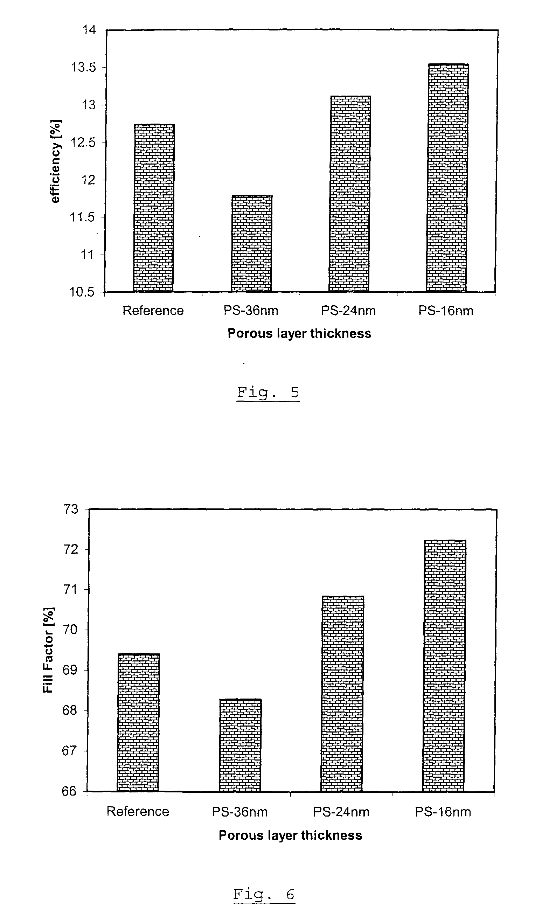

Fig. 3, Fig. 4, Fig. 5 and Fig. 6 are representing measurements of typical solar cell parameters as there are respectively the short circuit current *J*_{*sc*} *[mA*/*cm*^{*2*}*],* the open circuit voltage *V*_{*oc*}[*mV*]*,* efficiency η [%] and fill factor *FF* [%], based on typical but specific layer thicknesses for the emitter layer and the bulk layer, this for a reference, further mentioned below, and for different thicknesses of the porous layer: 16nm, 24nm, 36nm.

A preferred embodiment consists of a multi crystalline Silicon substrate (Baysix, carrier concentration of about 10¹⁶cm⁻³), on which a porous layer is electrochemically elaborated, having a thickness with a value between 15nm - 20nm and a porosity of about 20%. The remaining non-porous part of the wafer is p-doped. A PECVD process is used to deposit an amorphous silicon layer on top with a thickness of about 10-15 nm, which has been hydrogenated and n-doped. (carrier concentration of about 10¹⁹ *cm*⁻³).

The results indicate an optimal porous layer thickness to be preferably around 16nm, while for larger and smaller values the efficiency decreases, and indicate that the concept works for a thickness of the porous layer within the range of [1nm, 50nm] for typical emitter thickness, which is preferably within the range of [3nm, 100nm] .

The efficiency is higher then in an prior art reference device where substantially non-doped amorphous silicon was used for the third layer, as illustrated in Tab. 2.

The reference device consists of a p-doped multi crystalline Silicon wafer (Baysix, carrier concentration of about 10¹⁶ *cm*⁻³), on which a 5nm thick layer of intrinsic amorphous silicon is deposited via a PECVD technique. Another PECVD process is used to deposit an amorphous silicon layer on top with a thickness of about 10-15 nm, which has been hydrogenated and n-doped (carrier concentration of about 10¹⁹ *cm*⁻³).

**Tab. 2:**

| comparison of characteristic parameters between the invention and an equivalent study with a substantially non-doped amorphous third layer. | | | | |
|---|---|---|---|---|
| | *V*_{*oc*} [*mV*] | *J*_{*sc*} [*mA*/*cm*²] | *FF*[%] | *η*[%] |
| Invention | 579 | 32.63 | 75 | 14.2 |
| Amorphous non-doped silicon as thin film layer | 572.0 | 30.08 | 76.6 | 13.2 |

A first characteristic of the invention is that substantially non-doped porous silicon based on crystalline silicon has electrical characteristics (carrier concentration is in the region of 10¹² *cm*⁻³ *-*10¹³ *cm*^{*-*}³ ) similar to those of substantially non-doped amorphous silicon (carrier concentration is in the region of 10¹¹cm⁻³) , more precisely it is not conductive, but it has lower absorption characteristics then amorphous silicon. Non-doped amorphous silicon absorbs substantially more light. This implies that the present invention can have a thicker third layer (in the art called 'thin film layer'), improving robustness against diffusion of Indium atoms coming from the ITO towards the bulk material.

Moreover porous silicon is intrinsically hydrogen (H) rich, increasing passivation. Since grain boundaries between neighboring single crystals in a multi crystalline layer also increase recombination activity of the cell, it needs to be passivated. In the presence of Aluminum (A1), typically used as electrode material, H atoms coming from the porous silicon are diffusing quicker through the multi crystalline silicon and an improved passivation of the bulk material is achieved ['Synergetic effect of Aluminum and thermally treated porous silicon for bulk passivation of multi crystalline silicon', R. Bilyalov, Z. Matic, J. Poortmans, F. Schomann, W. Schmidt, Conference Record of the Twenty-Eighth IEEE Photovoltaic Specialists Conference - 2000 (Cat. No. 00CH37036). IEEE, Piscataway, NJ, USA; 2000; xxxii+1838 pp. p. 291-4].

Porous silicon can be achieved by electrochemical etching or chemical etching.

A second characteristic of the invention is that after the production of the porous layer by elaboration of the second layer, no extra plasma-cleaning step can be required before adding the amorphous emitter layer on top, which would be needed in case of a substantially non-doped amorphous silicon thin film as third layer.

Moreover in the latter case a wet cleaning step is required before the PECVD process that deposits for instance the substantially non-doped amorphous silicon thin film, which implies that the deposition of electrode material on the backside, typically Aluminum, can only be performed after the wet cleaning process, polluting the front surface. In the case of a substantially non-doped porous thin film, where the porous layer is made through electrochemical etching this contamination will be removed during the production process.

In the case of a porous layer formed by chemical etching, the production of the device represented in Fig. 2, where the multi crystalline or mono crystalline bulk layer has to be on both sides covered with porous silicon material, can be simplified, since both layers can be formed simultaneously.

The invention also relates to a photovoltaic device (Fig. 2B), whereby the second layer of (Fig. 1A) is further attached to a fourth layer (7) made of porous substantially non-doped silicon semiconductor material, based on crystalline semiconductor material, which is on its turn attached to a fifth layer (8) based on amorphous silicon semiconductor material and of the same conductivity type as the second layer, similar to the photovoltaic cell construction as in [Toru Sawada, Norihiro Terada, Sadaji Tsuge, Toshiaki Baba, Tsuyoshi Takahama, Kenichiro Wakisaka, Shinya Tsuda and Shoichi Nakano, High-efficiency a-Si/c-Si hetero junction solar cell, First WCPEC , Hawaii, 1994, pp. 1219-1226].

## Claims

1. A photovoltaic device, comprising a first layer of a first semiconductor material of a first conductivity type, a second layer of a second semiconductor material of the opposite conductivity type of said first layer, and a third layer of a third semiconductor material wherein:
- said third layer is located between said first layer and said second layer; and
- said third layer is porous.

2. The photovoltaic device according to claim 1, wherein the first semiconductor material, the second semiconductor material and the third semiconductor material are based on the same chemical element or chemical element combination.

3. The photovoltaic device according to claim 1, wherein the second semiconductor material and the third semiconductor material are based on the same chemical element or chemical element combination.

4. The photovoltaic device according to claim 3, wherein the chemical element is silicon.

5. The photovoltaic device according to claim 1 to 4, wherein the third semiconductor material is non-doped.

6. The photovoltaic device according to claim 1 to 5, wherein the third semiconductor material is crystalline.

7. The photovoltaic device according to claim 1 to 6, wherein said third layer is based on material selected from the group consisting of multi crystalline semiconductor material and mono crystalline semiconductor material.

8. The photovoltaic device according to claim 1 to 7, wherein the second layer is based on crystalline semiconductor material.

9. The photovoltaic device according to claim 8, wherein the second layer is based on material selected from the group consisting of mono crystalline semiconductor material and multi crystalline semiconductor material.

10. The photovoltaic device according to claim 1 to 9, wherein the said first layer has a thickness between 3nm and 100nm.

11. The photovoltaic device according to claim 1 to 10, wherein the third layer has a thickness between 1nm and 50nm.

12. A method for providing a photovoltaic device comprising the steps of:
- providing the second layer described in any of the previous claims; and
- depositing the third layer described in any of the previous claims on said second layer; and
- depositing the first layer described in any of the previous claims on said third layer.

13. A photovoltaic device according to claim 1 to 11, whereby the second layer is further attached to a fourth layer which is porous and based on a fourth semiconductor material, said fourth semiconductor material being non-doped crystalline silicon semiconductor material, and said fourth layer being attached to a fifth layer based on material selected from the group consisting of amorphous silicon semiconductor material, nano crystalline semiconductor material and micro crystalline silicon semiconductor material, said fifth layer being of the same conductivity type as the said second layer.

14. A method according to claim 12 further comprising the steps of:
- depositing the fourth layer described in claim 13 on said second layer; and
- depositing the fifth layer described in claim 13 on said fourth layer.
